Europäisches Patentamt

European Patent Office

Office européen des brevets

(11) Publication number: **0 190 151**
**B1**

# (12) EUROPEAN PATENT SPECIFICATION

(45) Date of publication of patent specification: **23.08.89**

(51) Int. Cl.⁴: **F 01 N 5/02, H 01 L 35/30**

(21) Application number: **85902418.4**

(22) Date of filing: **22.05.85**

(86) International application number:
**PCT/AU85/00111**

(87) International publication number:
**WO 85/05406 05.12.85 Gazette 85/26**

(54) THERMO-ELECTRIC GENERATOR.

(30) Priority: **24.05.84 AU 5159/84**

(43) Date of publication of application:
**13.08.86 Bulletin 86/33**

(45) Publication of the grant of the patent:
**23.08.89 Bulletin 89/34**

(84) Designated Contracting States:
**AT BE CH DE FR GB IT LI LU NL SE**

(56) References cited:
**DE-A-3 308 798**
**DE-C- 388 487**
**DE-C- 398 950**
**DE-C- 695 955**
**DE-C-1 111 460**
**FR-A- 575 273**
**FR-A- 620 472**
**FR-A-1 165 740**
**FR-A-2 512 499**
**US-A-3 297 492**
**US-A-3 719 532**
**US-A-4 095 998**
**US-A-4 204 882**

(73) Proprietor: **SWARBRICK, Alan**
**No. 3 Residence 'Colanda'**
**Colac, VIC 3250 (AU)**

(72) Inventor: **SWARBRICK, Alan**
**No. 3 Residence 'Colanda'**
**Colac, VIC 3250 (AU)**

(74) Representative: **Miller, Joseph et al**
**J. MILLER & CO. Lincoln House 296-302 High Holborn**
**London WC1V 7JH (GB)**

Courier Press, Leamington Spa, England.

## Description

This invention relates to an improved generator and more particularly to a voltage generator which is suitable for use with engines such as, for example, internal combustion engines.

One particular application of the present invention is in connection with motor vehicles and it will be convenient to describe the invention with reference to that particular application. It is to be understood, however, that this is not to be taken as a limitation on the scope of the invention as it will be readily apparent that the voltage generator could be used in a wide variety of applications.

Motor vehicles are generally fitted with an electrical generator for meeting the electrical requirements of the vehicle. The generator is usually in the form of an alternator which produces alternating current or in some cases in the form of a dynamo which produces direct current. Both devices are relatively complicated in their structure and because of the number of moving parts tend to suffer from mechanical failure.

The present invention seeks to provide an improved voltage generator powered from a source of waste heat, which is suitable for use with an internal combustion engine, in particular to utilise heat from the engine exhaust.

Prior art generators for the generation of electricity from waste heat are known from US-A-4,095,998 and US-A-3,297,492 in which a voltage generator is described comprising thermoelectric generators extending between a zone maintained at a high temperature by a source of waste heat and a lower temperature zone defined by fins positioned in a cooling air flow. The thermoelectric generators are in the form of semiconductor devices which are susceptible to damage at high temperatures, which restricts the temperature range of operation. The fins are arranged externally of the semiconductor devices which span a space between the heat source and the fins so that the overall temperature gradient established across the devices by the fins is limited. Another prior art thermoelectric generator is shown in DE-C-695,955.

In accordance with the present invention a voltage generator comprising thermoelectric generators extending between a zone maintained at high temperature by a source of waste heat and a zone at a lower temperature defined by a plurality of fins positioned in a cooling airflow to develop a temperature gradient, is characterised in that the fins are elongate and arranged in a bank with their axes substantially parallel, each fin having a first longitudinal edge in direct thermal contact with the source of waste heat so as to define a high temperature zone of the fin in the vicinity of the first edge, a second longitudinal edge opposite the first edge and spaced from the heat source, the said second edges of the fins being un-enclosed free edges, the bank of fins being located within an airflow such that cooling air can pass freely along the fins so that the fins are cooled to define a low temperature zone of the fin in the vicinity of the second edge portion thereof, and the generators comprise a multiplicity of thermocouples mounted on each fin with each thermocouple having one junction in the high temperature zone of the fin and one junction in the low temperature zone of the fin.

The voltage generator of the invention may be particularly characterised in that the source of waste heat is an exhaust pipe of an internal combustion engine and the fins are arranged around it with their longitudinal axes substantially parallel to the axis of the pipe, the first longitudinal edges of tbe fins being in direct thermal contact with the pipe and the second edges being disposed radially outwardly of the first edges.

In a practical embodiment of the invention the said multiplicity of thermocouples are connected with one group thereof in series and a further group in parallel whereby to generate determined voltage and current values when a given temperature gradient is formed between the high temperature zones and the low temperature zones of the fins.

One embodiment of the invention will hereinafter be described with reference to the accompanying drawings in which:

Figure 1 is a schematic perspective view of a generator according to the invention; and

Figure 2 is a diagram of one proposed array of thermocouples for use in the generator of the present invention.

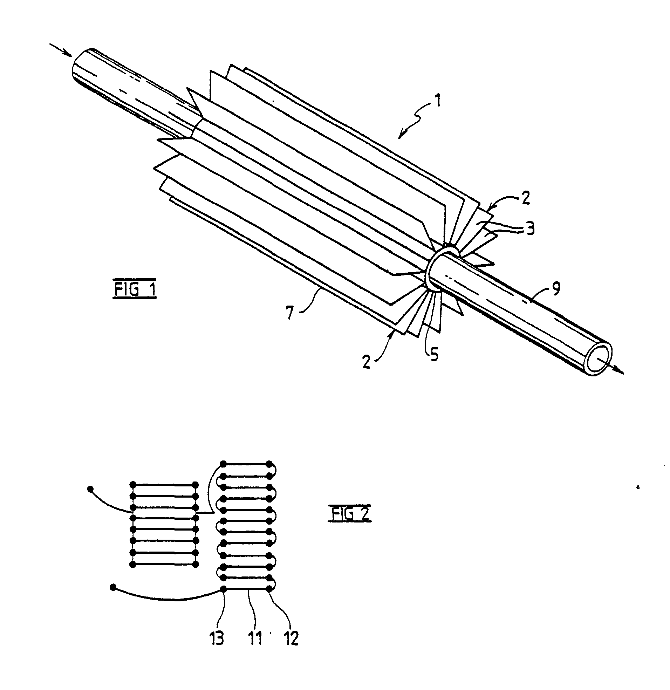

Referring to the drawings, the generator of the present invention generally indicated at 1 comprises a plurality of thermocouples 11 having alternating hot and cold junctions 12 and 13, the thermocouples 13 being arranged in electrical series and/or parallel (see Figure 2). The hot junctions of the thermocouples are mounted adjacent a relatively hot zone of the engine when the engine is in operation, the cold junctions being spaced from the relatively hot zone so that the heat of the engine in the hot zone causes a voltage to be produced by the plurality of thermocouples. The heat zone of the engine is, as shown, a waste heat zone such as the engine exhaust or the like.

As shown, the thermocouples are mounted on support members 2 in banks. The support members are in the form of elongated fins 3 having one longitudinal edge 5 mounted in the hot zone with the fin projecting away from the hot zone, the other longitudinal edge 7 having the cold junctions of the thermocouples disposed thereat. In the embodiment shown the fins 3 are mounted with the inner longitudinal edge abutting against the exhaust pipe 9 of the internal combustion engine and the outer longitudinal edge projecting away therefrom. As shown, a plurality of fins 3 are arranged on the exhaust pipe 9 the fins being circumferentially disposed therearound. The inner longitudinal edge 5 of each fin 3 may be bonded to the others so as to collect maximum heat. Whilst it is appreciated that any number of fins could be utilised, in one particular arrangement 20 fins are provided around the exhaust pipe of the engine each fin containing a hundred thermocouples thereon. A convenient size of the fin is 30 cm by 6 cm. The outer longitudinal edges of the fins are spaced apart so that air can freely pass along and between the outer edge portions of each fin and thereby facilitate more efficient heat exchange.

It will be appreciated that many types of thermocouples would be suitable for use in the generator of the present invention, however, exmples of two preferred forms are the nickel chromium thermocouple or nickel aluminium thermocouple the properties of which are set out in British Standard 1827. These particular thermocouples are capable of generating a voltage of 10.57 mv each at a temperature of 200°C.

It will be seen in Figure 2 that a number of the thermocouples are arranged in series and a further group are arranged in parallel so as to obtain maximum current and voltage. It is proposed that the generator of the present invention could be used as a boost to normal electrical generation or alternatively completely to substitute for the now known rotary generator.

## Claims

1. A voltage generator comprising thermoelectric generators (11) extending between a zone maintained at high temperature by a source (9) of waste heat and a zone at a lower temperature defined by a plurality of fins positioned in a cooling airflow to develop a temperature gradient, characterised in that the fins (3) are elongate and arranged in a bank with their axes substantially parallel, each fin (3) having a first longitudinal edge (5) in direct thermal contact with the source of waste heat so as to define a high temperature zone of the fin (3) in the vicinity of the first edge (5), a second longitudinal edge (7) opposite the first edge (5) and spaced from the heat source (9), the said second edges (7) of the fins (3) being un-enclosed free edges, the bank of fins (3) being located within an airflow such that cooling air can pass freely along the fins so that the fins are cooled to define a low temperature zone of the fin (3) in the vicinity of the second edge portion thereof, and the generators (11) comprise a multiplicity of thermocouples mounted on each fin (3) with each thermocouple having one junction in the high temperature zone of the fin (3) and one junction in the low temperature zone of the fin (3).

2. A voltage generator according to Claim 1, characterised in that the source of waste heat is an exhaust pipe (9) of an internal combustion engine and the fins (3) are arranged around it with their longitudinal axes substantially parallel to the axis of the pipe (9), the first longitudinal edges (5) of the fins being in direct thermal contact with the pipe (9) and the second edges (7) being disposed radially outwardly of the first edges.

3. A voltage generator according to Claim 1 or Claim 2, characterised in that the said multiplicity of thermocouples (11) are connected with one group thereof in series and a further group in parallel whereby to generate determined voltage and current values when a given temperature gradient is formed between the high temperature zones and the low temperature zones of the fins (3).

## Patentansprüche

1. Spannungsgenerator mit thermoelektrischen Generatoren (11), die sich zwischen einer durch eine Abwärmequelle auf einer hohen Temperatur gehaltenen Zone und einer auf einer niedrigeren Temperatur liegenden, von mehreren in einem Kühlluftstrom angeordneten Rippen gebildeten Zone zur Erzeugung eines Temperaturgradienten erstrecken, dadurch gekennzeichnet, daß die Rippen (3) länglich ausgebildet und in einer Gruppe mit im wesentlichen parallelen Achsen angeordnet sind, wobei jede Rippe (3) eine erste Längskante (5) aufweist, die in direktem thermischen Kontakt mit der Abwärmequelle steht, damit in der Nähe der ersten Kante (5) eine Hochtemperaturzone der Rippe (3) entsteht, eine zweite Längskante (7) gegenüber der ersten Kante (5) im Abstand von der Abwärmequelle (9) aufweist, wobei die zweiten Kanten (7) der Rippen (3) nicht umhüllte freie Kanten sind und die Gruppe der Rippen (3) innerhalb eines Luftstroms angeordnet ist, so daß Kühlluft frei längs der Rippen strömen kann, so daß die Rippen gekühlt werden und eine Niedertemperaturzone der Rippe (3) in der Nähe ihres zweiten Randbereichs entsteht, und daß die Generatoren (11) aus mehreren Thermoelementen bestehen, die an jeder Rippe (3) angebracht sind, wobei jedes Thermoelement eine Verbindung mit der Hochtemperaturzone der Rippe (3) und eine Verbindung mit der Niedertemperaturzone der Rippe (3) aufweist.

2. Spannungsgenerator nach Anspruch 1, dadurch gekennzeichnet, daß die Abluftquelle ein Auspuffrohr (9) einer Brennkraftmaschine ist und daß die Rippen (3) mit ihren Längsachsen im wesentlichen parallel zur Achse des Rohrs (9) um dieses Rohr herum angeordnet sind, wobei die ersten Längskanten (5) der Rippen in direktem thermischen Kontakt mit dem Rohr (9) stehen, während die zweiten Kanten (7) radial außerhalb der ersten Kanten angeordnet sind.

3. Spannungsgenerator nach Anspruch 1 oder Anspruch 2, dadurch gekennzeichnet, daß die mehreren Thermoelemente (11) so miteinander verbunden sind, daß eine Gruppe in Serie geschaltet ist und eine weitere Gruppe parallelgeschaltet ist, wodurch vorbestimmte Spannungs- und Stromwerte erzeugt werden, wenn ein gegebener Temperaturgradient zwischen den Hochtemperaturzonen und den Niedertemperaturzonen der Rippen (3) erzeugt ist.

## Revendications

1. Générateur de tension comprenant des générateurs thermoélectriques (11) s'étendant entre une zone maintenue à haute température par une source (9) de chaleur de déperdition et une zone maintenue à une température plus basse, définie par une pluralité d'ailettes placées dans un courant d'air de refroidissement afin de développer un gradient thermique, caractérisé en ce que les ailettes (3) sont de forme allongée et disposées en batterie avec leurs axes substantiellement parallèles, chaque ailette (3) ayant un premier bord longitudinal (5) en contact thermique direct avec la source de chaleur de déperdition de manière à définir une zone à haute température sur l'ailette (3) à proximité du premier bord (5) et un deuxième bord longitudinal (7) à l'opposé du premier bord (5) et écarté de la source de chaleur (9), lesdits deuxièmes bords (7) des ailettes (3) étant des bords libres et non enfermés, la batterie d'ailettes (3) étant située dans un flux d'air tel que l'air de refroidissement peut circuler librement le long des ailettes afin de refroidir les ailettes et de définir une zone à basse température de l'ailette (3) à proximité de la partie du second bord, et les générateurs (11) comprennent une multiplicité de thermocouples montés sur chaque ailette (3), chaque thermocouple ayant un raccord dans la zone à haute température de l'ailette (3) et un raccord dans la zone à basse température d l'ailette (3).

2. Générateur de tension selon la revendication 1, caractérisé en ce que la source de chaleur de déperdition est un tuyau d'échappement (9) d'un moteur à combustion interne et en ce que les ailettes (3) sont montées autour de lui, leurs axes longitudinaux étant substantiellement parallèles à l'axe du tuyau (9), les premiers bords longitudinaux (5) des ailettes étant en contact thermique direct avec le tuyau (9) et les deuxièmes bords (7) étant disposés radialement à l'extérieur des premiers bords.

3. Générateur de tension selon la revendication 1 ou 2, caractérisé en ce que les thermocouples de ladite multiplicité de thermocouples (11) sont reliés en série pour un groupe et en parallèle pour un autre groupe, afin de produire une tension et une valeur de courant déterminées lorsqu'il se forme un gradient thermique donné entre les zones à haute température et les zones à basse température des ailettes (3).

FIG 1

FIG 2